# EUROPEAN PATENT APPLICATION

(11) **EP 1 243 672 A1**
(43) Date of publication of application: **25.09.2002**
(21) Application number: 00985819.2
(22) Date of filing: 21.12.2000
(51) Int. Cl.: C25D 19/00

(54) **PLATING DEVICE AND PLATING METHOD**

(30) Priority: 24.12.1999 JP 36842199; 06.06.2000 JP 2000169632; 30.06.2000 JP 2000199814; 04.12.2000 JP 2000369122
(71) Applicant: SPC Electronics Corporation, Chofu-shi, Tokyo 182-8602 (JP)
(72) Inventor: 0NOBATA, Hirotaka SPC Electronics Corporation, Chofu-shi Tokyo 182-8602 (JP); SONODA, Haruki, SPC Electronics Corporation, Shimada-shi, Shizuoka-ken 427-0006 (JP); TATEHABA, Yoshihito, SPC Electronics Corporation, Chofu-shi, Tokyo 182-8602 (JP); OHTSUBO, Tetsurou, SPC Electronics Corporation, Shimada-shi, Shizuoka-ken 427-0006 (JP); MORITO, Yasuomi, SPC Electronics Corporation, Shimada-shi, Shizuoka-ken 427-0006 (JP); SHIMADA, Kiyoshi, SPC Electronics Corporation, Chofu-shi, Tokyo 182-8602 (JP); ABE, Yusuke, SPC Electronics Corporation, Chofu-shi, Tokyo 182-8602 (JP); ANDO, Ei'ichi, SPC Electronics Corporation, Shimada-shi, Shizuoka-ken 427-0006 (JP); ISHI, Tetsuji, SPC Electronics Corporation, Shimada-shi, Shizuoka-ken 427-0006 (JP)
(74) Representative: Becker Kurig Straus
(86) International application number: JP0009096
(87) International publication number: WO01048275

(57) **Abstract**

A plating apparatus and plating method for an electronic component substrate or the like which prevent the spread of metal contamination in and out of the plating apparatus, do not dissolve a seed layer, have no defects caused by scattering of a treating liquid and wash only the perimeter of the electronic component substrate or the like are provided. The plating apparatus is a plating apparatus for plating an object to be plated such as an electronic component substrate. The plating apparatus includes appropriate numbers of plating baths and baths used for washing or other purposes therein and carries out plating, edge etching, washing and drying continuously therein.

## Description

### Technical Field

The present invention relates to a plating apparatus and a plating method for plating an object to be plated such as an electronic component substrate. More specifically, it relates to a plating apparatus and plating method in which a disk object to be plated such as a semiconductor wafer or a hard disk is subjected to electrolytic plating and the object is then held to be rotated and washed with a cleaning liquid.

### Background Art

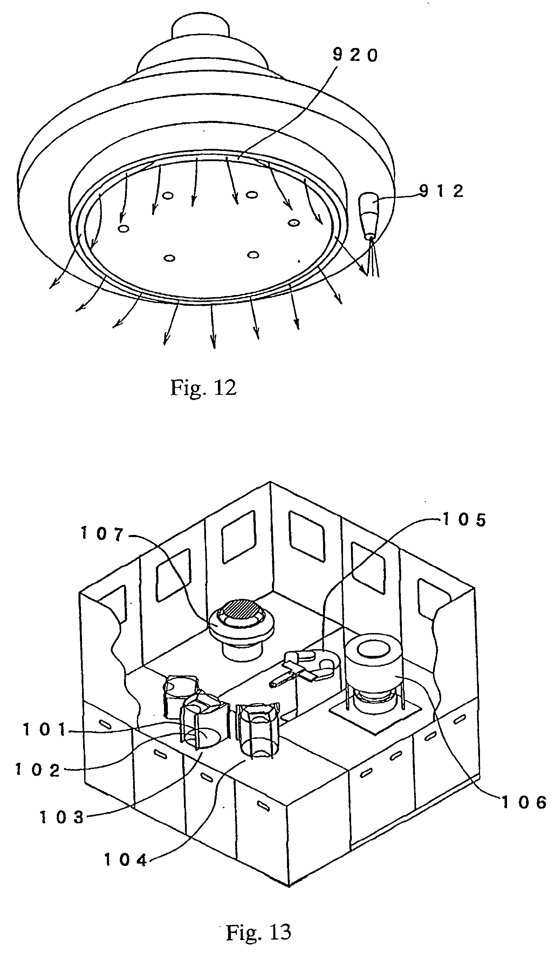

As an example of conventional plating apparatuss, a plating apparatus for subjecting a semiconductor wafer 101 as an object to be plated to electrolytic plating is shown in Fig. 13. Although this plating apparatus comprises a plating bath 106 and a washing bath 107, it adopts such a constitution of a general apparatus for plating the semiconductor wafer 101 automatically that the apparatus has a loader 103 and an unloader 104 and uses a transfer robot 105 for transfer. In plating, the semiconductor wafer 101 as an object to be plated is taken out of a storage by the transfer robot 105 or a transfer cassette (to be referred to as "cassette" hereinafter) 102 and charged into the plating bath 106. After completion of plating, the semiconductor wafer 101 is taken out of the plating bath 106 by the same transfer robot 105 and then charged into the washing bath 107. After completion of washing, the semiconductor wafer 101 is taken out of the washing bath 107 by the same transfer robot 105 and then stored in the cassette 102 of the unloader 104.

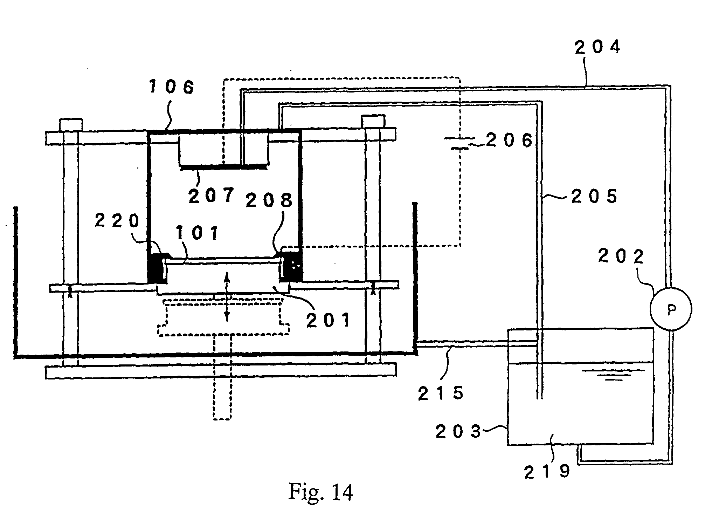

In the case of an apparatus having such a constitution, there is the possibility that the atmosphere of a metal containing plating solution 219 (refer to the conventional plating bath of Fig. 14) may diffuse into the washing section or the loader and unloader sections. In the production process of semiconductors, contamination by metals such as copper has a significant effect on the electric characteristics of semiconductor chips. Therefore, it is one of important objects to prevent diffusion of an atmosphere containing metals.

Further, when the semiconductor wafer 101 is plated, metals deposited from the plating solution 219 may be deposited around its perimeter on its end face. The metals are not easily rinsed from the wafer 101 by pure water, and when the wafer 101 is placed in the cassette 102 with the metals thereon, metal contamination may spread out through the cassette 102. therefore, it is necessary to avoid deposition of unwanted metals around the perimeter of the semiconductor wafer 101 especially where the wafer 101 comes in contact with the cassette 102.

A plating bath 106 is shown in Fig. 14 as one example of conventional plating baths. The plating bath 106 is a plating bath 106 for subjecting a semiconductor wafer 101 as an object to be plated to electrolytic plating. In electrolytic plating by the plating bath 106, the semiconductor wafer 101 is placed at the bottom of the plating bath 106, and a plating solution 219 is supplied into and discharged and recovered from the plating bath 106 from its upper portion. Thus, the occurrence of non-uniform plating caused by air bubbles is prevented.

In the upper portion of the inside of the plating bath 106, an anode electrode 207 is provided, and in the bottom portion of the inside thereof, a cathode electrode 208 and a wafer mounting table 201 are provided. On the wafer mounting table 201, the semiconductor wafer 101 as an object to be plated is placed. The wafer mounting table 201 can be moved from the bottom portion of the plating bath 106 in a vertical, downward direction. The arrow in Fig. 14 indicates vertical movement of the wafer mounting table 201. As the wafer mounting table 201 moves upward toward the bottom of the plating bath 106, it is stopped at the position where it closes the bottom of the plating bath 106. Thereby, the semiconductor wafer 101 is pressed against and comes in close contact with the plating bath 106 to form the bottom of the plating bath 106.

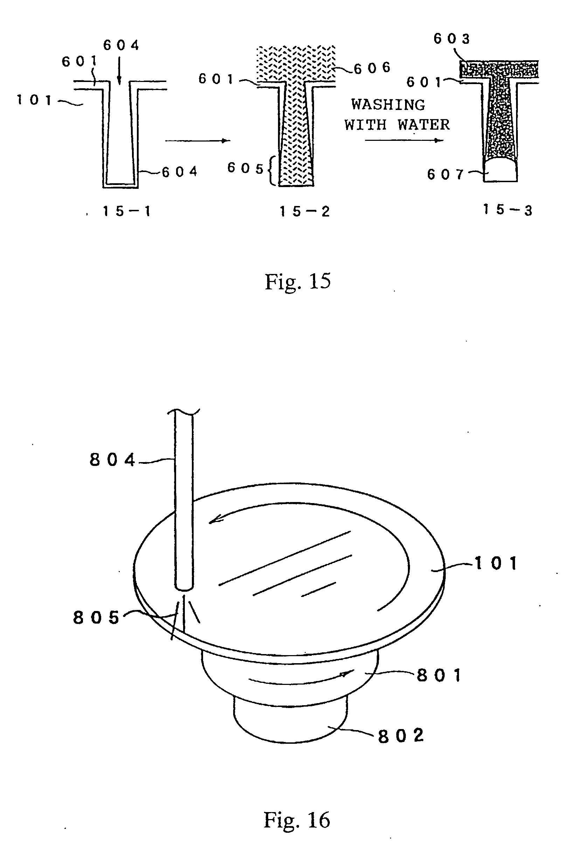

Thereafter, the plating solution 219 is supplied from a plating solution tank 203 to the plating bath 106 by a circulation pump 202 through a supply pipe 204. When the plating bath 106 is filled with the plating solution 219, the plating solution 219 is recovered to the plating solution tank 203 via a drain pipe 215. At the same time, a current passes though the semiconductor wafer 101 from a plating power source 206 through the anode electrode 207 and the cathode electrode 208, thereby plating the wafer 101. After completion of plating, the circulation pump 202 is stopped, and the plating solution remaining in the plating bath 106 is sent back to the plating solution tank 203 via the drain pipe system 215 by means of gravity or gas. Further, the conventional plating apparatus has such a structure that the plating solution tank 203 is disposed under or away from the plating bath 106 and the plating solution 219 is supplied to the plating bath 106 through the circulation pump 202 at the time of plating. Therefore, it takes time that the plating solution 219 reaches the anode electrode 207 from the surface of the semiconductor wafer 101 so as to be able to pass a current, thereby dissolving a seed layer 601 (refer to Fig. 15).

When the semiconductor wafer 101 is plated with, for example, copper, in this plating bath 106, a thin backing copper film (to be refereed to as "seed layer 601" hereinafter) for passing a current is provided on the semiconductor wafer 101 in the above step. However, since a general copper sulfate based plating solution 219 is strongly acid, the seed layer 601 starts to dissolve upon contact with the plating solution 219. When the seed layer 601 is etched and therefore has an irregular surface, a current does not pass through its discontinuous portions, thereby making plating impossible. Further, although varying depending on the thickness of the film and the concentration and temperature of the plating solution 219, as the wiring pattern of a semiconductor becomes finer, the seed layer 601 tends to become thinner, so that the seed layer 601 is etched in a very short time to the extent that it become discontinuous. Thus, the etching problem is becoming unable to be dealt with only by controlling the temperature of the solution and an electric current, and the time between when the semiconductor wafer 101 comes in contact with the plating solution 219 and when a current start to pass must be made as short as possible.

Fig. 15 shows a schematic diagram of copper plating on a semiconductor wafer 101 to form a wiring pattern thereon as one example of conventional plating methods. Fig. 15-1 shows a step of forming a seed layer 601, Fig. 15-2 shows the state of the wafer 101 immediately after the initiation of a copper sulfate plating step, and Fig. 15-3 shows the state of the wafer 101 after the completion of the copper sulfate plating step. When the seed layer 601 is formed on a fine wiring pattern with a tall aspect ratio on the semiconductor wafer 101, it is difficult to form a sufficiently thick film at the bottoms of pits of the pattern by means of a conventional sputtering method. As shown in Fig. 15-1, the wiring pattern on the semiconductor wafer 101 has pits 604. When the seed layer 601 is formed on the wiring pattern and the wiring pattern is then filled with a plating film (external plating layer 603) to be deposited by means of a conventional electrolytic copper sulfate plating method, the thin seed layer 601 is dissolved by a copper sulfate plating solution 219 which is strongly acid between the moment when the semiconductor wafer 101 has just come in contact with the plating solution 219 and when a current starts to pass to carry out plating as described above (Fig. 15-2). As the current for electrolytic plating does not pass through dissolved portions, as a result, such problems as voids occur (Fig. 15-3).

To solve such a problem, some patent publications such as Japanese Patent Application No. 315385/1999 disclose a method using a pyrophosphoric acid-based copper plating solution. However, the pyrophosphoric acid-based copper plating solution is of little practical use since it has the following problems.
(1) The components of the solution are susceptible to natural degradation and unstable.
(2) Since sodium (to be referred to as "Na" hereinafter) is mixed in during the production process of the pyrophosphoric acid-based copper plating solution, Na may be present in a formed film. In the production of semiconductors which are still becoming finer, the presence of Na which is a conductive substance in wiring changes electric characteristics, whereby satisfactory performance cannot be obtained. Otherwise, it becomes a defect.
(3) In the case of a copper sulfate-based copper plating solution, copper ions dissolved in the solution are agglomerated, precipitated and recovered when the solution is discharged. However, in the case of the pyrophosphoric acid-based copper plating solution, since copper does not agglomerate and precipitate, it is difficult to discharge the solution.

Fig. 16 shows an example of a conventional rotating washing bath for a semiconductor wafer 101. A conventional washing bath 107 (shown in Fig. 14) comprises a rotatable table 801 which holds the semiconductor wafer 101 as an object to be plated horizontally and rotates the wafer 101, a motor 802 which drives the rotatable table 801, and a cleaning liquid supply means 804 for jetting a cleaning liquid 805 against the perimeter of the semiconductor wafer 101 which is held on the rotatable table 801 and rotates. In this case, the rotatable table 801 has a holding mechanism to mount and hold the semiconductor wafer 101 thereon and is disposed such that it is supported by the rotation axis of the motor 802 and rotates as the motor 802 drives. Therefore, the rotatable table 801 is formed such that it can wash the semiconductor wafer 101 by holding the wafer 101 by means of the holding mechanism and rotating the wafer 101 by means of the driving force from the motor 802. In addition, above the rotatable table 801, the cleaning liquid supply means 804 for supplying the cleaning liquid 805 against the perimeter of the rotating semiconductor wafer 101 is provided. The cleaning liquid supply means 804 is a jet nozzle for jetting the cleaning liquid 805 and is disposed such that it jets the cleaning liquid 805 against the perimeter of the semiconductor wafer 101 which is held on the rotatable table 801 and rotates to wash the wafer 101 by means of the pressure of the jetted liquid.

To wash the semiconductor wafer 101 with the thus formed conventional washing bath 107 (shown in Fig. 14), firstly, the semiconductor wafer 101 which has undergone a predetermined step (for example, resist application step) is held and transferred to the top surface of the rotatable table 801 by transfer means and mounted on the table 801. Further, after the semiconductor wafer 101 is mounted on the top surface of the rotatable table 801 as described above, the semiconductor wafer 101 is held by means of the holding mechanism of the rotatable table 801 and fixed on the top surface of the rotatable table 801. Thereafter, when the motor 802 is driven to rotate the rotatable table 801, the semiconductor wafer 101 held on the rotatable table 801 rotates together with the table 801. Then, the cleaning liquid 805 is jetted from the cleaning liquid supply means 804 against the perimeter of the semiconductor wafer 101 held on and rotating together with the rotatable table 801 to wash its perimeter with the jetted cleaning liquid 805. As described above, in the case of the conventional washing bath 107, the semiconductor wafer 101 is mounted on and rotated with the rotatable table 801, and the perimeter of the semiconductor wafer 101 is washed by means of the pressure of the cleaning liquid 805 jetted from the cleaning liquid supply means 804.

However, in the conventional washing bath 107, as shown in Fig. 16, when the cleaning liquid 805 has started to be jetted from the cleaning liquid supply means 804, the cleaning liquid 805 scatters toward the center of the semiconductor wafer 101, thereby producing defects on the surface of the semiconductor wafer 101, with the result of a significant decrease in manufacturing yields.

In consideration of the above problems, the objects of the present invention are to prevent diffusion of metal contamination into and out of the apparatus, to achieve good plating without causing a seed layer to dissolve at the time of plating an electronic component substrate, to prevent the occurrence of defects casued by a cleaning liquid scattered toward the center of an object to be washed at the time of washing the object and to provide a plating apparatus and plating method for an electronic component substrate or the like which are capable of washing only the perimeter of the substrate effectively.

### Disclosure of the Invention

A plating apparatus and plating method for an electronic component substrate or the like according to the present invention use the following means. The attached numerals coincide with those in the drawings.

The plating apparatus according to the present invention is a plating apparatus for plating an object to be plated such as an electronic component substrate. The apparatus includes appropriate numbers of plating baths and baths used for washing or other purposes therein and is constituted such that plating, edge etching, washing and drying processes are carried out continuously in the apparatus.

A bath used for washing or other purposes in the present invention is preferably capable of not only washing but also etching of substrate edges and drying. However, as a matter of course, it is also possible to form independent baths for discrete purposes such as edge etching and drying.

Further, the plating apparatus of the present invention is more preferably constituted such that it has a plurality of plating baths and baths used for washing or other purposes and a series of the aforementioned processes are carried out in the integral apparatus. Such a constitution is effective.

In addition, the plating apparatus according to the present invention is divided into three areas, i.e., a first area in which plating baths are placed, a second area in which edge etching, washing and drying are carried out, and a third area which is a loader and unloader area. The areas are separated from one another by means of separation parts and together constitute an integral plating apparatus.

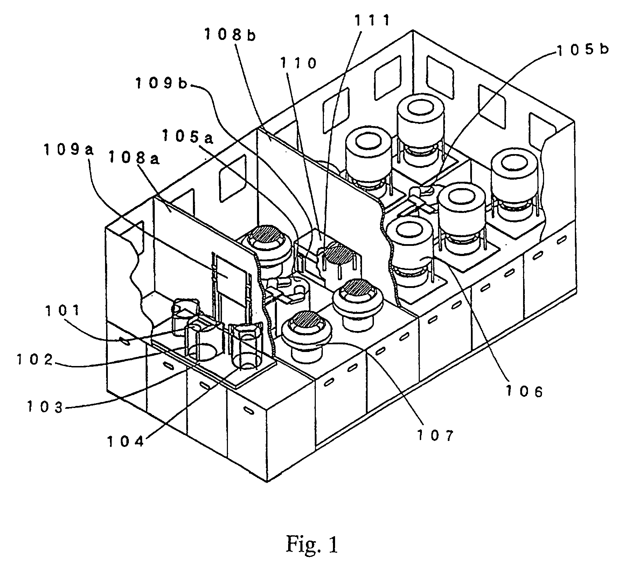

Next, the detailed constitution of the plating apparatus (refer to Fig. 1) of the present invention will be described hereinafter. The plating apparatus of the present invention is an apparatus which includes a plating bath 106, a bath 107 used for washing or other purposes, a loader 103, an unloader 104, and a transfer robot 105 as transfer means therein. The plating apparatus of the present invention is divided into three areas, i.e., a plating area in which the plating bath 106 is placed, an area in which the bath 107 is placed to carry out washing and drying, and a loader and unloader area, and has partitions 108a and 108b as separation parts between the areas. The partitions each have an opening in an area through which an electronic component substrate (semiconductor wafer) 101 passes. The plating apparatus for an electronic component substrate or the like of the present invention has a shutter 109a at the opening of the partition 108a and a BOX 110 which is polyhedral or cylindrical and has a mechanism for holding an electronic component substrate therein and a shutter 109b at each area side. The BOX 110 which is polyhedral or cylindrical and has a mechanism for holding an electronic component substrate therein and the shutter 109b at each area side may be constituted by two or more layers.

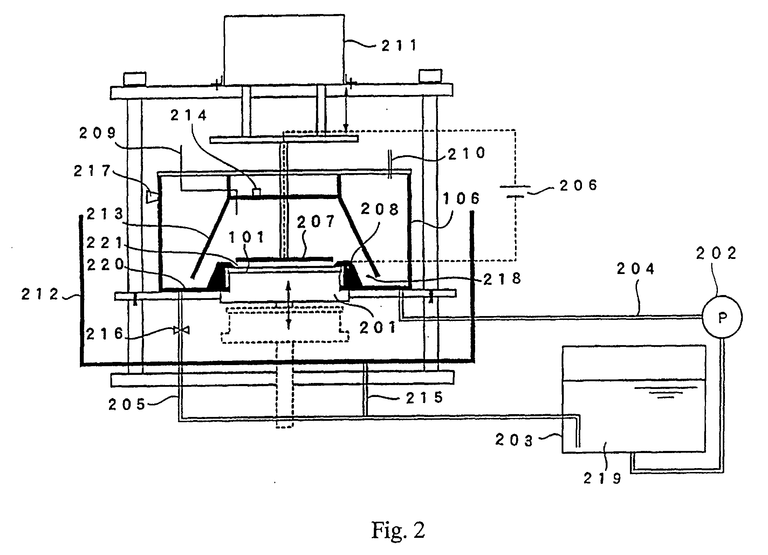

Further, the plating bath 106 (refer to Fig. 2) to be mounted on the plating apparatus of the present invention has a mounting table 201 for the electronic component substrate (semiconductor wafer) 101 which is an object to be plated in the bottom 220 and a cover 213 which is almost cylindrical or almost hollow square and opened toward the bottom 220 of the plating bath 106, has a plating solution supply space 218 and covers the electronic component substrate (semiconductor wafer) 101 which is an object to be plated. A plating solution 219 is supplied to the plating bath 106 until a predetermined amount of the solution 219 is stored, and the cover 213 is then opened to let air come in so as to supply the plating solution 219 from the plating solution supply space 218 into the inside of the cover 213.

Further, the plating bath 106 may also have an opening 221 which corresponds to the plating surface of the electronic component substrate (semiconductor wafer) 101 which is an object to be plated at the bottom 220 and a cathode electrode 208 which comes in contact with the electronic component substrate (semiconductor wafer) 101 which is an object to be plated.

Still further, the cover 213 may have an anode electrode 207 which opposes to the object to be plated 101.

Still further, the anode electrode 207 of the cover 213 may be freely movable in a vertical direction such that the electrode 207 is located no more than a few millimeters right above the semiconductor wafer 101 which is an object to be plated at the time of supplying the solution onto the surface of the semiconductor wafer 101 which is an object to be plated, i.e., at the time of passing a current and the electrode 207 is then moved to a certain height, which is a standard position, in relation to the semiconductor wafer 101 which is an object to be plated.

Also, the mounting table 201 of the object to be plated 101 may be freely movable in a vertical direction under the plating bath 106 and comes in contact with the cathode electrode 208 at the highest reachable position to constitute the bottom 220 of the plating bath 106.

The cover 213 may also have an air releasing valve at the top.

The cover 213 may also have a nitrogen supply pipe 219.

The plating bath 106 may also have an air releasing pipe 210 at the top.

The plating bath 106 may also have a solution surface detecting sensor 217 on the side.

In addition, a drain cover 212 may also be provided that recovers the plating solution 219 flowing out of the plating bath 106 when the mounting table 201 descends.

A brief description of a plating bath to be mounted on the plating apparatus for an electronic component substrate or the like of the present invention will be given hereinafter. The semiconductor wafer (object to be plated) 101 is disposed in the bottom 220 portion of the plating bath 106 in contact with the cathode electrode 208, the cover 213 is fixed right above the semiconductor wafer 101 in such a manner that the opened side of the cover 213 faces the wafer 101, the inside of the cover is pressurized, and the plating solution is injected between the plating bath 106 and the cover 213 once. Thereafter, air is allowed to come in the inside of the cover 213 to introduce the plating solution 219 onto the surface of the semiconductor wafer 101 by use of a pressure difference. Further, the anode electrode 207 is mounted on the cover 213 and can be moved vertically from a seed layer protection energization point right above the semiconductor wafer 101 which is an object to be plated to a certain height. When the plating solution 219 is introduced onto the surface of the semiconductor wafer 101, the cover 213, i.e., anode electrode 207, is fixed at the seed layer protection energization point right above the semiconductor wafer 101. At this point, a spacing between the semiconductor wafer 101 and the anode electrode 207 is several millimeters or less. For this reason, a retention time until the wafer 101 can be energized in the case of a low film formation amount can be made as close to zero as possible. Then, the plating solution 291 is supplied again, the anode electrode 207 is raised to a predetermined position and a set current is passed through the anode electrode 207 to carry out plating. According to such a constitution, a time to fill the spacing between the semiconductor wafer 101 and the anode electrode 207 with the solution after air is allowed to come inside the cover 213 becomes approximately zero, thereby making it possible to eliminate the stagnation time until energization. Consequently, plating can be carried out without dissolving a thin film on a wafer.

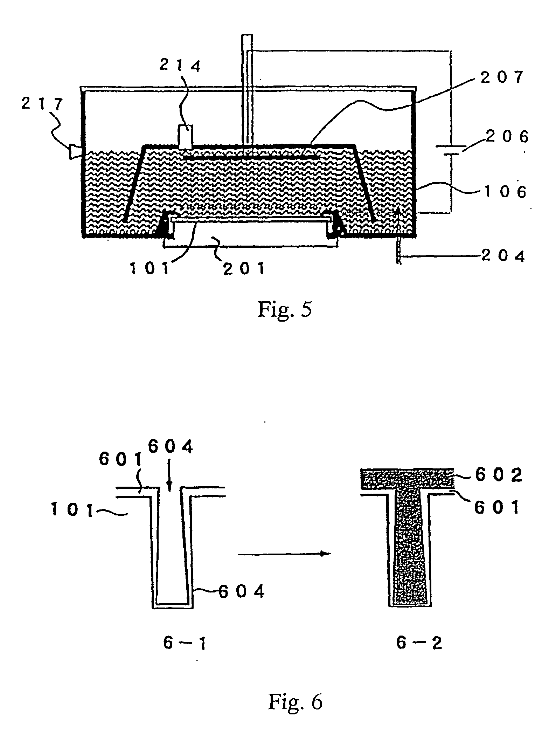

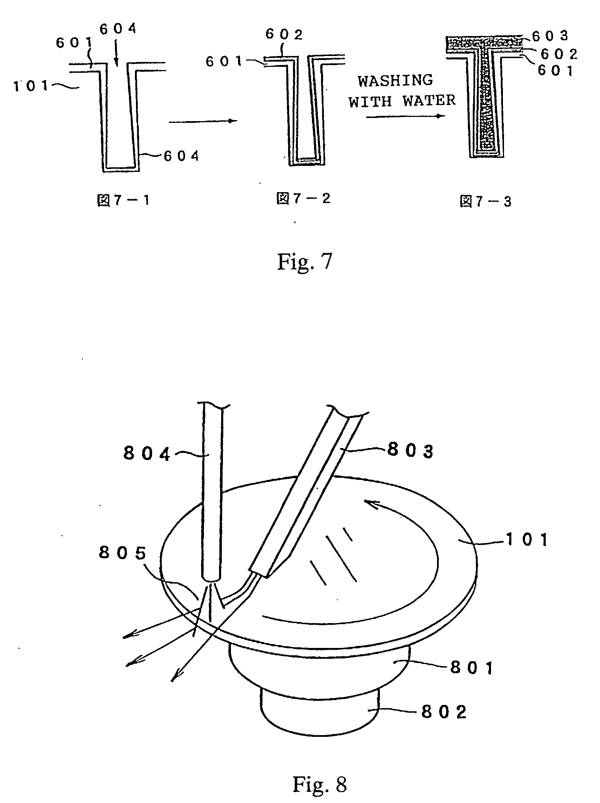

Figs. 6 and 7 show an example of plating methods that can be applied to the plating bath to be mounted on the plating apparatus for an electronic component substrate or the like according to the present invention. An electrolytic plating method applied to the above plating bath includes a step of plating a seed layer 601 formed on a wiring pattern with a phosphonic acid, amine or acetic acid based electrolytic copper plating solution having a low seed layer dissolving speed to fill pits 604 of the wiring pattern. An electrolytic copper plating solution 605 used in this plating step may be neutral, alkalescent or acescent with a pH of 6.5 to 8.5. Further, this plating step may comprise a primary plating step in which a reinforcement layer 602 for reinforcing the seed layer 601 is formed and a secondary plating step in which the pits 604 of the wiring pattern are filled. In this case, an electrolytic copper plating solution 605 used in the primary plating step is a phosphonic acid, amine or acetic acid based electrolytic copper plating solution having a low seed layer dissolving speed, and its copper concentration is the most appropriately 7 to 12 g/l (grams/liter). With this copper concentration, uniform plating can be achieved, thereby making it possible to form an appropriate reinforcement layer and eliminating the possibility that the bottoms of some pits 604 of the wiring pattern are left unreinforced. Further, it is preferred to carry out plating in the secondary plating step with an electrolytic copper sulfate plating solution 219 having a pH of not higher than 6.5. In addition, as an anode electrode 207, a soluble anode such as phosphorus-containing copper or an insoluble anode such as platinum-coated titanium or iridium oxide may be provided.

Further, the plating apparatus according to the present invention has a plurality of plating baths 106 therein, and these plating baths 106 each have a similar solution system. The solution systems of the plating baths 106 may be independent of one another. In this case, a plurality of plating solutions 219 may be used in the apparatus.

Figs. 8 to 12 show an example of the bath used for washing or other purposes which is mounted on the plating apparatus of the present invention. A bath 107 used for washing or other purposes which is mounted on the plating apparatus of the present invention washes the perimeter of an object 101 to be washed with a cleaning liquid 805 while rotating the object 101. The bath 107 comprises a rotatable table 801 which holds and rotates the object 101, a cleaning liquid supply means 804 for supplying the cleaning liquid 805 to the perimeter of the object 101 which is held on the rotatable table 801 and rotates, and fluid jetting means 803 for preventing the cleaning liquid 805 supplied to the perimeter of the object 101 from scattering toward the center of the object 101 to contaminate the surface of the object 101 by jetting the fluid onto the surface of the object 101 from the center side toward the perimeter side of the object 101.

The fluid jetting means 803 is a jet nozzle which jets the fluid and which is preferably disposed in the vicinity of the cleaning liquid supply means 804 such that it jets the fluid at the surface of the object 101 from the center side toward the perimeter side of the object 101. Further, in another embodiment of the fluid jetting means 803, it preferably has a concave cross section, extends from the perimeter side to the center side of the object 101, surrounds the cleaning liquid 805 supplied from the cleaning liquid supply means 804 and jets the fluid at the surface of the object 101 to prevent the cleaning liquid 805 from scattering. In still another embodiment of the fluid jetting means 803, it is preferred that the bath 107 have a jet nozzle which jets the fluid in an annular shape from above the object 101 along the perimeter of the object 101 and the cleaning liquid supply means 804 be disposed in the vicinity of the jet nozzle but in a position closer to the perimeter of the object 101 than the jet nozzle is. The fluid to be jetted from the fluid jetting means 803 is desirably either gas such as air, nitrogen, argon, helium or carbon dioxide or a liquid such as pure water, hydrofluoric acid, ammonia, hydrochloric acid or sulfuric acid. Further, the cleaning liquid supply means 804 is preferably a jet nozzle which jets the cleaning liquid 805 at the perimeter of the object 101 to wash the perimeter with the jetted liquid. Further, the object 101 is an object 101 to be washed such as a disk-shaped semiconductor wafer or hard disk, and it is preferable to wash its perimeter with the cleaning liquid 805 in order to remove excess resists and contaminants such as plating deposited on the perimeter.

### Brief Description of the Drawings

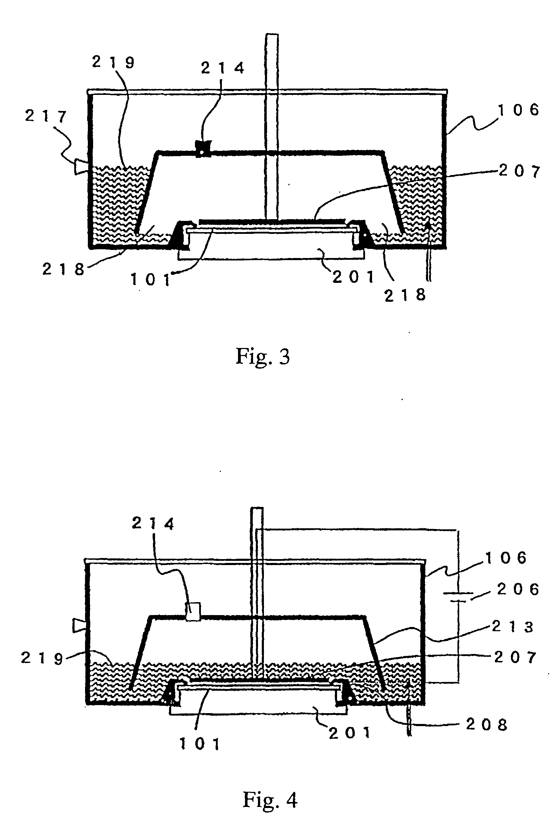

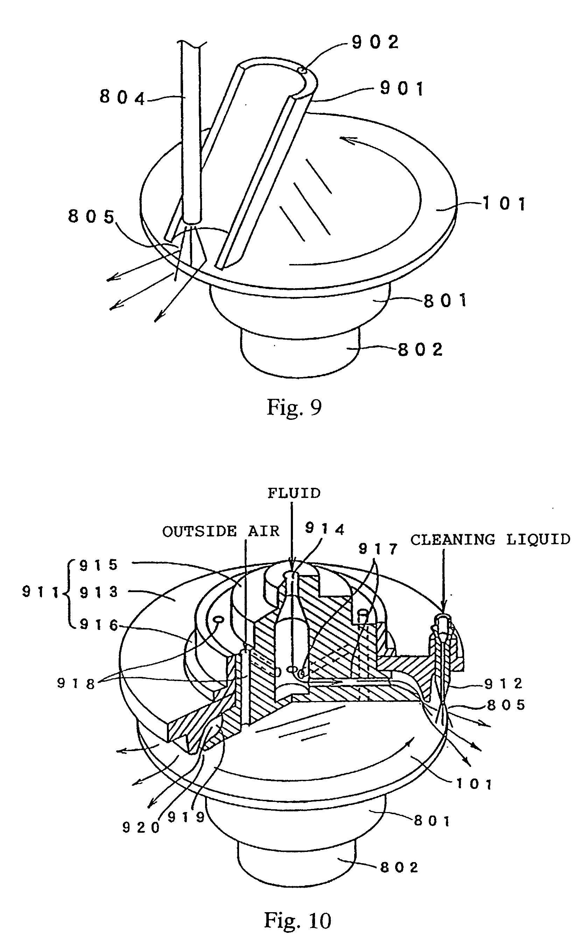

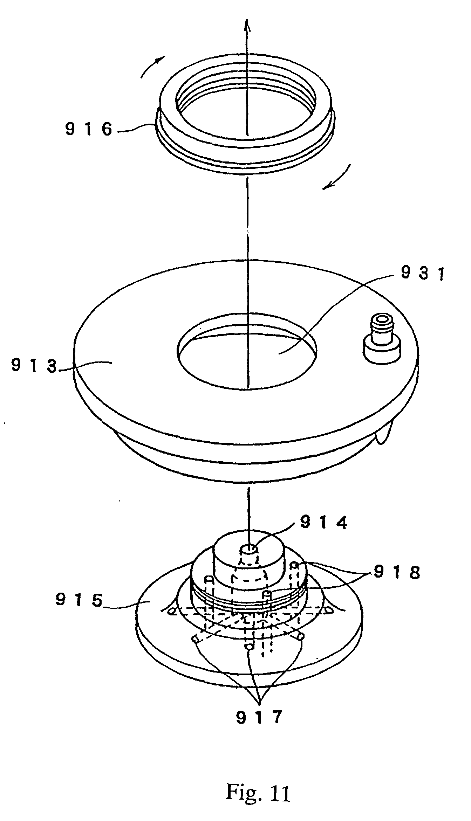

Fig. 1 is a perspective diagram illustrating one embodiment of a plating apparatus according to the present invention. Fig. 2 is a cross-sectional diagram illustrating one embodiment of a plating bath to be mounted on the plating apparatus according to the present invention and associated facilities. Fig. 3 is a cross-sectional diagram of the plating bath to be mounted on the plating apparatus according to the present invention at the time of supplying a plating solution (before energization). Fig. 4 is a cross-sectional diagram of the plating bath to be mounted on the plating apparatus according to the present invention upon initiation of plating. Fig. 5 is a cross-sectional diagram of the plating bath to be mounted on the plating apparatus according to the present invention after an anode electrode has ascended after initiation of plating. Fig. 6 shows an embodiment of a plating method applicable to the plating bath to be mounted on the plating apparatus according to the present invention. Fig. 6-1 is a schematic diagram illustrating the formation of a seed layer, and Fig. 6-2 is a schematic diagram illustrating filling pits on a wiring pattern only by means of reinforcement plating (alkalescent plating). Fig. 7 shows an embodiment of a plating method applicable to the plating bath to be mounted on the plating apparatus according to the present invention. Fig. 7-1 shows the formation of a seed layer, Fig. 7-2 shows a primary plating (alkalescent plating), and Fig. 7-3 shows a secondary plating (acescent plating). Fig. 8 is a perspective diagram illustrating a first embodiment of a bath used for washing or other purposes which is mounted on the plating apparatus according to the present invention. Fig. 9 is a perspective diagram illustrating a second embodiment of the bath used for washing or other purposes which is mounted on the plating apparatus according to the present invention. Fig. 10 is a perspective diagram illustrating a third embodiment of the bath used for washing or other purposes which is mounted on the plating apparatus according to the present invention. Fig. 11 is an exploded perspective diagram illustrating in detail the internal structure of the fluid jetting means shown in Fig. 10. Fig. 12 is a diagram illustrating the fluid jetting means shown in Fig. 10 with the fluid jetted therefrom.

Fig. 13 is a perspective diagram illustrating a conventional plating apparatus. Fig. 14 is a cross-sectional diagram illustrating a plating bath in the conventional plating apparatus. Fig. 15 is a schematic diagram illustrating a conventional wiring process (production process). Fig. 15-1 shows a step of forming a seed layer, Fig. 15-2 shows an acescent plating step immediately after the step has started, and Fig. 15-3 shows the acescent plating step after the step has completed. Fig. 16 is a perspective diagram illustrating a conventional washing bath employed for washing a wafer.

### Best Mode for Carrying Out the Invention

The embodiments of the plating apparatus according to the present invention will be described in detail with reference to the drawings hereinafter.

Fig. 1 shows an example of the constitution of the plating apparatus according to the present invention. Main constituents associated with the present invention are a semiconductor wafer (object to be plated), a cassette for storing or transferring the wafer (cassette) 102, a loader 103, an unloader 104, a semiconductor wafer transfer robot (transfer robot) 105a and 105b, a bath (plating bath) 106, a bath 107 for washing or other purposes, a partition 108a which is an separation part between a washing area and a loader and unloader area, a partition 108b which is an separation part between a plating area and the washing area, a shutter 109a, a shutter 109b, and a BOX (wafer passing unit) 110 which is polyhedral or cylindrical and has a mechanism for holding an electronic component substrate therein and a shutter at each area side.

A basic transfer flow in plating the electronic component substrate (semiconductor wafer) 101 is as follows. The semiconductor wafer 101 is taken out of the cassette 102 which is mounted on the loader 103 by means of the transfer robot 105a, placed in the wafer passing unit 110, and taken out of the wafer passing unit 110 and introduced into the plating bath 106 by means of the transfer robot 105b. After completion of plating, the semiconductor wafer 101 is taken out of the plating bath 106 by means of the same transfer robot 105b, placed in the wafer passing unit 110, and taken out of the wafer passing unit 110 and introduced into the bath 107 which is used for washing or other purposes by means of the transfer robot 105a. After completion of edge etching, washing and drying processes, the semiconductor wafer 101 is taken out of the bath 107 by means of the transfer robot 105a and then placed in the cassette 102 mounted on the unloader 104. In this flow, when the semiconductor wafer 101 is taken out of the cassette mounted on the loader 103 or placed in the unloader 104 by means of the transfer robot 105a, the shutter 109a opens, whereas the semiconductor wafer 101 is placed in the wafer passing unit 110 by means of the transfer robot 105a or 105b, the shutter 109b opens. The shutters 109a and 109b are otherwise closed, and the partitions 108a and 108b and the shutters 109a and 109b separate the loader and unloader area, the washing area and the plating area from one another to isolate atmospheres thereof from one another. Further, the plating apparatus for an electronic component substrate or the like according to the present invention has a mechanism for washing the perimeter of the object 101 to be plated after plating the object 101.

Figs. 2 to 5 show facilities associated with the plating bath of the plating apparatus according to the present invention. Fig. 2 shows mainly a cross-sectional diagram and piping diagram of the facilities associated with the plating bath of the present invention, and Figs. 3 to 5 show mainly introduction of a plating solution into the plating bath. Main constituents associated with the present invention are a semiconductor wafer (object to be plated) 101, a wafer mounting table 201, a plating bath 106, a circulation pump 202, a plating solution tank 203, a supply pipe 204, drain pipes (205 and 215), a plating power source 206, an anode electrode 207, a cathode electrode 208, a nitrogen pipe 209, an air releasing pipe 210, a cylinder 211, a drain cover 212, a cover 213, an air release valve 214, a valve 216, a solution surface detecting sensor 217, a plating solution supply space 218, a plating solution 219, a plating bath bottom 220 and plating bath bottom opening 221.

As shown in Fig. 2, in the plating bath 106, the cover 213 which opens wide from the center of the top of the bath 106 toward its bottom side is provided and covers the semiconductor wafer 101, the wafer mounting table 201, the anode electrode 207, the cathode electrode and the like on the bottom side of the bath 106. The cover 213 is almost cylindrical or almost hollow square and opened toward the bottom 220 of the plating bath 106. In Figs. 2 to 5, the cover 213 is shown in the shape of nearly a lamp shade or nearly an inverted pot. The cover 213 is disposed with some spacing (that is, plating solution supply space 218) between the bottom of the plating bath 106 and itself, and the plating solution can flow into or out of the inside of the cover 213 through the spacing. Further, the cover 213 has the air release valve 214 which can be opened and closed freely to let in and out air at the top.

The principle of the present invention according to such a constitution is that the plating solution 219 is introduced and kept temporarily between the plating bath 106 and the outside of the cover 213, and when the air release valve 214 is opened to release the air under the cover 213, the plating solution 219 can be introduced onto the surface of the semiconductor wafer 101 in a stroke due to a difference in pressure between the inside and outside of the cover 213.

After the semiconductor wafer 101 is mounted on the mounting table 201, the mounting table 201 ascends with the semiconductor wafer 101 thereon and comes in contact with the cathode electrode 208. At this point, the semiconductor wafer 101 closes the bottom 220 of the plating bath 106 by coming in contact with a sealing material attached to the bottom 220 of the plating bath 106. Then, the valve 216 is closed, and the plating solution 219 in the plating solution tank 203 is supplied to the plating bath 106 through the supply tank 204 by means of the circulation pump 202. At this point, the anode electrode 207 attached to the cover 213 is fixed at a seed layer protection energization point right above the semiconductor wafer 101 by means of the cylinder 211, and nitrogen is supplied through the nitrogen pipe 209 with the air release valve 214 closed and the air releasing pipe 210 opened to increase the internal pressure inside the cover 213.

Then, as shown in Fig. 3, the plating solution 219 is introduced into the plating bath 106 in an amount only sufficient to fill a spacing between the anode electrode 207 and the semiconductor wafer 101 until the solution surface detecting sensor 217 is activated and kept there temporarily. At this point, the plating solution 219 does not go inside the cover 213 since the inside of the cover 213 is filled with nitrogen whose pressure is higher than the pressure of the plating solution kept temporarily between the cover 213 and the internal surface of the plating bath. Further, as shown in Fig. 4, after an appropriate amount of the plating solution 219 is supplied to and kept in the plating bath 106 (Fig. 3), a small amount of current is passed from the power source 206, the supply of nitrogen is stopped and the air release valve 214 is opened, whereby the plating solution 219 is supplied into the inside of the cover 213 instantaneously. At this point, a current flows between the anode electrode 207 and the cathode electrode 208, and plating of low film formation amount is initiated on the semiconductor wafer 101.

Then, as shown in Fig. 5, while the plating solution 219 is further supplied through the supply pipe 204 until the solution surface detecting sensor 217 is activated again to increase the amount of the plating solution in the plating bath 106, the cover 213 having the anode electrode 207 attached thereto is elevated from the seed layer protection energization point right above the semiconductor wafer 101 to a predetermined height by means of the cylinder 211. Then, a specified current is passed from the power source 206 to carry out plating. After completion of plating, the plating solution 219 is discharged from the plating bath by opening the valve 216 as shown in Fig. 2 and put back into the plating solution tank 203 through the drain pipe 205. Then, the mounting table 201 having the semiconductor wafer 101 thereon is lowered, and the semiconductor wafer 101 is taken out. The plating solution 219 flowing out of the plating bath when the semiconductor wafer 101 is taken out is recovered into the plating solution tank 203 through the drain pipe 215 after falling into the drain cover 212.

Next, a plating method which is applied to the plating bath of the plating apparatus according to the present invention will be described with reference to Figs. 6 and 7. Firstly, a description will be given with reference to Fig. 6. In a method for filling a wiring pattern on the semiconductor wafer 101 with copper, plating is deposited uniformly on a thin seed layer 601 within the wiring pattern without dissolving the seed layer 601 by use of a phosphonic acid, amine or acetic acid based electrolytic copper plating solution 605 which has a low seed layer dissolving speed to increase the thickness of the backing copper film so as to reinforce the seed layer 601 and to fill pits 604 of the wiring pattern. In the above method, these processes are performed in a single step to form an external plating layer 603. In this case, the phosphonic acid, amine or acetic acid based electrolytic copper plating solution 605 which has a low seed layer dissolving speed is used.

Next, a description will be given with reference to Fig. 7. In another method for filling a wiring pattern on the semiconductor wafer 101 with copper, plating is deposited uniformly on a thin seed layer 601 within the wiring pattern without dissolving the seed layer 601 by use of a phosphonic acid, amine or acetic acid based electrolytic copper plating solution 605 which dissolves the seed layer 601 slowly and has a uniform electrodeposition property to increase the thickness of the backing copper film so as to form a reinforcement layer 602 for reinforcing the seed layer 601. These processes constitute a first stage called a "primary plating step".

Then, after the reinforcement plating process for forming the reinforcement layer 602 in the primary plating step (first stage) is completed, the layer 602 is fully washed with water. In a secondary plating step (second stage), the reinforcement electrolytic copper plating film (reinforcement layer 602) is subjected to filling plating (secondary plating) using a copper sulfate plating solution 219 to form an external plating layer 603 thereon. In this case, although the reinforcement electrolytic copper plating film is dissolved to some extent by the copper sulfate plating solution 219 which is strongly acid between when the copper sulfate plating solution 219 has come in contact with the semiconductor wafer 101 (substrate) and when energization is initiated, the reinforcement electrolytic copper plating film is not dissolved completely because it has a substantial film thickness. Thus, when the primary plating step and the secondary plating step are carried out continuously, i.e., when the filling plating is carried out with the copper film formed within the wiring pattern, the wiring pattern can be filled with copper without the occurrence of undeposited spots such as voids.

Further, as the copper sulfate plating solution 219 used in the second stage (secondary plating), a solution which is the same as that used in a conventional copper wiring process, particularly a solution having such a filling property which exhibits an excellent effect (bottom-up effect) of depositing plating preferentially at the bottoms of pits of a wiring pattern, is preferably used. As for the anode electrode 207 used in the plating bath to be mounted on the plating apparatus for an electronic component substrate or the like according to the present invention, a soluble anode such as phosphorus-containing copper or an insoluble anode such as platinum-coated titanium or iridium oxide can be selected according to the characteristics of a plating solution to be used. For example, a soluble anode which itself dissolves to supply copper ions is suitable for the strongly acid plating solution 219, whereas an insoluble anode is suitable for the neutral or alkalescent plating solution 605 because a soluble anode cannot dissolve in the solution 605 and the properties intrinsic to the anode cannot be obtained.

Further, as the plating power source 206 used in the plating apparatus for an electronic component substrate or the like according to the present invention, a pulse power source or PR power source having an excellent uniform electrodeposition property can be selected in addition to a general direct current power source.

Further, as described so far in relation to the electrolyte copper plating apparatus of the present invention, basically, all the processes including the last process of filling in the wiring pattern can be performed by use of only the primary plating (first stage) intended for the reinforcement of the seed layer. In that case, the step can be the same as that indicated as the electrolyte copper plating apparatus of claim 1. Therefore, when performing only the first stage (primary plating) is considered, it is considered that the secondary plating can be omitted particularly for a very fine wiring pattern. In that case, the plating method of the present invention can be more effective means.

Next, more specific embodiments will be presented. As the embodiment shown in Fig. 7, the case where a phosphonic acid, amine or acetic acid based electrolytic copper plating solution 605 is used in the primary plating step will be described hereinafter. After a seed layer (barrier layer) 601 is formed in a via hole of 0.18 to 0.25 µm, a plating film having a thickness of about 0.05 µm as primary plating is deposited uniformly in the via hole by use of the phosphonic acid, amine or acetic acid based electrolytic copper plating solution 605 which does not dissolve the seed layer 601 to reinforce the seed layer 601. Then, after the plating film is washed with water, filling is carried out to a desired film thickness (for example, 1 µm) as secondary plating by use of an electrolyte copper plating solution.

Meanwhile, as the embodiment shown in Fig. 6, the case where all the processes including filling is carried out only in a single plating step (primary plating step) will be described hereinafter. After a seed layer (barrier layer) 601 is formed in a via hole having a very small diameter of about 0.15 µm, a plating film having a thickness of about 1.0 µm is deposited not only in the via hole to fill in the via hole but also on the surface of the seed layer 601 by use of a phosphonic acid, amine or acetic acid based electrolytic copper plating solution 605 which does not dissolve the seed layer 601.

Further, the plating apparatus of the present invention may incorporate a plurality of plating baths 106 having the piping system as shown in Fig. 2, some of which carry out the primary plating while the others of which carry out the secondary plating. The constitution of the plating apparatus for an electronic component substrate or the like according to the present invention takes it into consideration that the above plating method can be carried out continuously in the apparatus.

Fig. 8 shows one embodiment of a bath used for washing or other purposes which is mounted on the plating apparatus according to the present invention. The bath shown in Fig. 8 is for wafer washing as in the case of the prior art shown in Fig. 16 and comprises a rotatable table 801 which holds a semiconductor wafer 101 which is an object to be washed horizontally and rotates the wafer 101, a motor 802 which rotates the rotatable table 801, and a cleaning liquid supply means 804 for jetting a cleaning liquid against the perimeter of the semiconductor wafer 101 which is held on the rotatable table 801 and rotates. In addition, in the first embodiment, unlike the prior art shown in Fig. 16, fluid jetting means 803 for jetting the fluid is disposed in the vicinity of the cleaning liquid supply means 804.

As for the rotatable table 801, similarly to the prior art shown in Fig. 16, it has a holding mechanism (not shown) to mount and hold the semiconductor wafer 101 thereon horizontally and is disposed such that it is supported by the rotation axis (not shown) of the motor 802 and rotates as the motor 802 drives. Therefore, the rotatable table 801 is constituted such that it holds the semiconductor wafer 101 by means of the holding mechanism and rotates the semiconductor wafer 101 by means of the driving force of the motor 802 in washing the semiconductor wafer 101.

Above the rotatable table 801, the cleaning liquid supply means 804 for supplying a cleaning liquid to the perimeter of the rotating semiconductor wafer 101 is provided. The cleaning liquid supply means 804 is a jet nozzle which jets a cleaning liquid 805 and is disposed such that it jets the cleaning liquid 805 at the perimeter of the semiconductor wafer 101 which is held on and rotates together with the rotatable table 801 to wash the perimeter with the pressure of the jetted liquid.

Further, in the proximity to the cleaning liquid supply means 804, unlike the prior art shown in Fig. 16, the fluid jetting means 803 for jetting the fluid from the center side toward the perimeter side of the semiconductor wafer 101 is provided. The fluid jetting means 803 is a jet nozzle which jets the fluid and is disposed such that it jets the fluid at the perimeter of the semiconductor wafer 101 from the center side toward the perimeter side of the wafer 101 so as to prevent the cleaning liquid 805 from scattering toward the center of the wafer 101 and contaminating its surface. To wash the semiconductor wafer 101, for example, a liquid such as deionized pure water or gas such as compressed air is preferably used as the fluid to be jetted from the fluid jetting means 803.

When the semiconductor wafer 101 is washed by use of the first embodiment of the thus constituted bath used for washing or other purposes which is mounted on the plating apparatus according to the present invention, firstly, the semiconductor wafer 101 which has undergone a predetermined step (such as a resist application step) is held and transferred to the top surface of the rotatable table 801 by not shown transfer means and mounted on the table 801. Further, after the semiconductor wafer 101 is mounted on the top surface of the rotatable table 801 as described above, the semiconductor wafer 101 mounted on the surface of the rotatable table 801 is held by means of the holding mechanism and fixed. Thereafter, when the motor 802 is driven to rotate the rotatable table 801, the semiconductor wafer 101 held on the rotatable table 801 rotates together with the table 801.

The fluid jetted by the fluid jetting means 803 from the center side toward the perimeter side of the rotating semiconductor wafer 101 prevents a cleaning liquid 805 from scattering over the surface of the semiconductor wafer 101. Further, a cleaning liquid 805 is jetted at the perimeter of the semiconductor wafer 101 from the cleaning liquid supply means 804 while the fluid is jetted at the perimeter of the semiconductor wafer 101 by the fluid jetting means 803. Thereby, the perimeter of the semiconductor wafer 101 is washed by the pressure of the cleaning liquid 805 jetted from the cleaning liquid supply means 804. As described above, according to the first embodiment of the bath used for washing or other purposes which is mounted on the plating apparatus for an electronic component substrate or the like according to the present invention, the cleaning liquid 805 jetted from the cleaning liquid supply means 804 is blown off the semiconductor wafer 101 by means of the fluid jetted from the fluid jetting means 803. Thereby, it can be prevented that the cleaning liquid 805 scatters over the central portion of the semiconductor wafer 101 and contaminates the surface of the semiconductor wafer 101 in washing its perimeter, only the perimeter of the semiconductor wafer 101 can be washed selectively, and manufacturing yields can be increased.

Next, a detailed description will be given to the second embodiment of the bath used for washing or other purposes which is mounted on the plating apparatus for an electronic component substrate or the like according to the present invention with reference to Fig. 9. The constituents of the second embodiment are the same as those of the first embodiment except for fluid jetting means 803 shown in Fig. 9. The same numerals are allocated to the same or equivalent constituents, and a description of the same constituent will be omitted. As shown in Fig. 9, the second embodiment of the bath used for washing or other purposes which is mounted on the plating apparatus for an electronic component substrate or the like according to the present invention is also used for wafer washing as in the case of the first embodiment shown in Fig. 8 and comprises a rotatable table 801 which has a holding mechanism (not shown) for mounting and holding a semiconductor wafer 101 which is an object to be washed on the rotatable table 801 and holds and rotates the semiconductor wafer 101 horizontally, a motor 802 which rotates the rotatable table 801, a cleaning liquid supply means 804 for jetting a cleaning liquid 805 at the perimeter of the semiconductor wafer 101 which is held on and rotates together with the rotatable table 801, and fluid jetting means 901 for jetting the fluid which is disposed in the vicinity of the cleaning liquid supply means 804.

Unlike the first embodiment, the fluid jetting means 901 has a concave or almost U-shaped cross section, extends from the perimeter side to the center side of the semiconductor wafer 101 and surrounds the cleaning liquid 805 jetted from the cleaning liquid supply means 804. Further, the fluid jetting means 901 has an inlet 902 for injecting the fluid at the upper end. The inlet 902 communicates with the lower end of the fluid jetting means 901 which comes in contact with the semiconductor wafer 101 to jet the fluid at the perimeter of the semiconductor wafer 101. Therefore, the fluid jetting means 901 is formed such that it surrounds a portion of the perimeter of the semiconductor wafer 101 so as to isolate the portion of the perimeter from the central portion of the semiconductor wafer 101 and jets the fluid within the isolated portion to prevent the cleaning liquid 805 from scattering over the central portion of the semiconductor wafer 101. Further, as in the case of the first embodiment, a liquid such as deionized pure water or gas such as compressed air is preferably used as the fluid jetted from the fluid jetting means 901.

When the semiconductor wafer 101 is washed by use of the second embodiment of the thus formed bath used for washing or other purposes which is mounted on the plating apparatus for an electronic component substrate or the like according to the present invention, firstly, the semiconductor wafer 101 which has undergone a predetermined step (such as a resist application step) is held and transferred to the top surface of the rotatable table 801 by not shown transfer means and mounted on the table 801. Further, after the semiconductor wafer 101 is mounted on the top surface of the rotatable table 801 as described above, the semiconductor wafer 101 mounted on the rotatable table 801 is held and fixed by means of the holding mechanism. Thereafter, when the motor 802 is driven to rotate the rotatable table 801, the semiconductor wafer 101 held on the rotatable table 801 rotates together with the table 801.

Further, a portion of the perimeter of the semiconductor wafer 101 is surrounded by the fluid jetting means 901 having a concave cross section so as to isolate the portion of the perimeter from the central portion of the semiconductor wafer 101, and the fluid injected from the inlet 902 is jetted within the isolated perimeter portion, thereby preventing the cleaning liquid 805 from scattering. The cleaning liquid 805 is jetted from the cleaning liquid supply means 804 at the portion of the perimeter of the semiconductor wafer 101 which is surrounded by the fluid jetting means 901. Thereby, the perimeter of the semiconductor wafer 101 is washed by the pressure of the cleaning liquid 805 jetted from the cleaning liquid supply means 804.

As described above, according to the second embodiment of the bath used for washing or other purposes which is mounted on the plating apparatus for an electronic component substrate or the like according to the present invention, since the fluid jetting means 901 prevents the cleaning liquid 805 from scattering over the central portion of the semiconductor wafer 101, the same effect as that of the first embodiment can be obtained. Further, according to the second embodiment, since the cleaning liquid supply means 804 is surrounded by the fluid jetting means 901 having an almost U shape, scattering of the cleaning liquid 805 can be minimized, and contamination of the semiconductor wafer 101 can be prevented effectively as compared with the first embodiment.

Next, a detailed description will be given to the third embodiment of the bath used for washing or other purposes which is mounted on the plating apparatus for an electronic component substrate or the like according to the present invention with reference to Figs. 10 to 12. The constituents of the third embodiment are the same as those of the first embodiment except for fluid jetting means 911 and cleaning liquid supply means 912 shown in Fig. 10. The same numerals are allocated to the same or equivalent constituents, and a description of the same constituent will be omitted.

As shown in Fig. 10, the third embodiment of the bath used for washing or other purposes which is mounted on the plating apparatus for an electronic component substrate or the like according to the present invention is also used for semiconductor wafer washing as in the case of the first embodiment shown in Fig. 8 and comprises a rotatable table 801 which has a holding mechanism (not shown) for mounting and holding a semiconductor wafer 101 which is an object to be washed on the rotatable table 801 and holds and rotates the semiconductor wafer 101 horizontally and a motor 802 which rotates the rotatable table 801.

Further, unlike the first embodiment, the third embodiment comprises the fluid jetting means 911 for jetting the fluid in an annular shape along the perimeter of the semiconductor wafer 101 which is held on and rotates together with the rotatable table 801 from above the semiconductor wafer 101 and the cleaning liquid supply means 912 which is mounted on the fluid jetting means 911 in order for jetting a cleaning liquid 805 at the perimeter of the semiconductor wafer 101.

The fluid jetting means 911 comprises a cup 913 which is formed in a nearly disk shape and has an opening 931 (refer to Fig. 11) formed in the center, a body 915 which fits in the opening 931 of the cup 913, and a lock nut 916 which screws onto the body 915 to fix the cup 913 on the body 915.

The body 915 has an inlet 914 which is a cylindrical opening formed in the center of the top of the body 915 for injecting the fluid and a plurality of breakthroughs 917 which radiate within the body 915 outwardly from the lower portion of the cylindrical inlet 914.

Therefore, as shown in Fig. 11, the body 915 is formed such that the fluid can be injected from the inlet 914 and discharged from the plurality of breakthroughs 917 which are open at the perimeter of the semiconductor wafer 101. Further, as shown in Figs. 10 and 11, the body 915 has, around the inlet 914, a plurality of outside-air inlets 918 which penetrate the body 915 from top to bottom without intersecting the breakthroughs 917 so as to take in outside air.

The thus formed body 915 is inserted into the opening 931 of the cup 913 shown in Fig. 11 and the lock nut 916 is fastened to the body 915 with the cup 913 therebetween, thereby forming the fluid jetting means 911. In the formation of the fluid jetting means 911, an annular chamber 919 is formed between the cup 913 and the body 915 along with the perimeter of the body 915 as shown in Fig. 10. Further, between the cup 913 and the body 915, a jet nozzle 920 which is apart from the perimeter of the semiconductor wafer 101 and communicates with the annular chamber 919 is formed. The annular chamber 919, as shown in Fig. 10, communicates with one ends of the breakthroughs 917 formed in the body 915. Therefore, the fluid jetting means 911 is formed such that the fluid is injected from the inlet 914, supplied to the annular chamber 919 through the breakthroughs 917 and jetted from the annular jet nozzle 920 which is opened against the surface of the semiconductor wafer 101 as shown in Fig. 12.

As for the fluid to be jetted from the jet nozzle 920, a liquid such as deionized pure water or gas such as compressed air is preferably used as in the case of the first embodiment. Further, unlike the first embodiment shown in Fig. 8, the cleaning liquid supply means 912 is provided at the perimeter of the cup 913 (refer to Fig. 10) so as to be able to jet the cleaning liquid 805 at the perimeter of the semiconductor wafer 101. The cleaning liquid supply means 912 is a jet nozzle which jets the cleaning liquid 805 and is disposed such that it can jet the cleaning liquid 805 at the perimeter of the semiconductor wafer 101 which is held on and rotates together with the rotatable table 801 as shown in Fig. 10. The jet nozzle 920 of the fluid jetting means 911 is provided in proximity of the cleaning liquid supply means 912 so as to be able to blow the cleaning liquid 805 jetted to wash the perimeter of the semiconductor wafer 101 off the semiconductor wafer 101.

Thus, the fluid jetting means 911 has the annular jet nozzle 920 shown in Fig. 12 which has a smaller diameter than that of the semiconductor wafer 101 formed between the body 915 and the cup 913 and has the cleaning liquid supply means 912 for jetting the cleaning liquid 805 at the perimeter of the semiconductor wafer 101 disposed in proximity of the jet nozzle 920.

When the semiconductor wafer 101 is washed by use of the third embodiment of the thus formed bath used for washing or other purposes which is mounted on the plating apparatus for an electronic component substrate or the like according to the present invention, the semiconductor wafer 101 which has undergone a predetermined step (such as a resist application step) is held by not shown transfer means, transferred between the fluid jetting means 911 and the rotatable table 801, mounted on the top surface of the rotatable table 801 and held by the holding mechanism provided on the rotatable table 801 to be fixed on the rotatable table 801.

Thereafter, when the motor 802 is driven to rotate the rotatable table 801, the semiconductor wafer 101 held on the rotatable table 801 rotates together with the table 801. At this point, a negative pressure is formed between the semiconductor wafer 101 and the fluid jetting means 911 and pulls the semiconductor wafer 101 toward the fluid jetting means 911. To prevent the formation of the negative pressure, the fluid jetting means 911 has a plurality of outside-air inlets 918 shown in Fig. 10 to take in outside air.

Then, the fluid is injected from the inlet 914 of the body 915 and jetted from the annular jet nozzle 920 at the perimeter of the semiconductor wafer 101 so as to prevent the cleaning liquid 805 from scattering over the central portion of the wafer 101. Thereafter, the cleaning liquid 805 is jetted from the cleaning liquid supply means 912 at the perimeter of the semiconductor wafer 101 to wash the perimeter by means of the pressure of the jetted cleaning liquid 805 as shown in Fig. 10.

As described above, according to the third embodiment of the bath used for washing or other purposes which is mounted on the plating apparatus for an electronic component substrate or the like according to the present invention, since the fluid jetting means 911 prevents the cleaning liquid 805 from scattering over the central portion of the semiconductor wafer 101, the same effect as that of the first embodiment can be obtained.

Further, according to the third embodiment, since the fluid is jetted from the annular fluid jetting means 911 along the whole perimeter of the semiconductor wafer 101, scattering of the cleaning liquid 805 can be minimized to prevent contamination of the semiconductor wafer 101 more effectively as compared with the first and second embodiments, and manufacturing yields can be increased.

Although the embodiments of the bath used for washing or other purposes which is mounted on the plating apparatus for an electronic component substrate or the like according to the present invention have been described in detail, the present invention is not limited to the aforementioned embodiments and can be modified without deviating from the scope of the present invention. For example, although the embodiments in which the bath used for washing or other purposes which is mounted on the plating apparatus for an electronic component substrate or the like according to the present invention is used for semiconductor wafer washing have been described, the bath is not limited to such use and can also be used for such an object to be washed as a hard disk.

### Effect of the Invention

As described above, the plating apparatus for an electronic component substrate or the like according to the present invention exhibits the excellent effects as described hereinafter.

Separation parts (partitions), shutters and wafer passing unit provided in between a loader and unloader area, a washing area and a plating area can prevent the atmosphere of each area from diffusing out of the area. Further, as a plating apparatus, its mechanism for etching edges can prevent the spread of metal contamination in and out of the apparatus.

Further, when a plating solution is supplied to a plating bath, the dissolution of a thin film on a wafer which occurs between when an anode electrode has come in contact with the plating solution and when plating becomes possible can be prevented, and undeposition of plating caused by the dissolution of the thin film can be avoided accordingly.

Further, according to the constitution of the plating apparatus according to the present invention, the time taken to inject the solution between the wafer and the anode electrode after the inside of a cover is opened to air becomes approximately zero, the retention time until energization can be eliminated, and plating can be carried out without dissolving the thin film on the wafer. As for the production of a semiconductor wafer, excellent plating can be carried out by use of an apparatus with a concise structure.

In addition, such a good filling property that does not allow the plating solution to dissolve a seed layer to cause undeposited spots such as voids can be secured. Further, the apparatus can be operated easily only by incorporating a single step and is highly practical. Still further, a plating film is deposited uniformly along the shape of a wiring pattern (via hole or trench) to reinforce a thin seed layer by a primary plating step using an electrolytic copper plating solution which is not strongly acid (neutral, alkalescent or acescent) and has a low seed layer dissolving speed and then filling plating which causes a plating film to be deposited preferentially at the bottoms of via holes is carried out by a secondary plating step using an electrolytic copper sulfate plating solution, thereby achieving a good filling property with the wiring pattern free of voids without dissolving the seed layer formed on a fine wiring pattern with a tall aspect ratio.

Furthermore, since a cleaning liquid and a fluid are supplied simultaneously to the perimeter of an object to be washed by cleaning liquid supply means and fluid jetting means with the object rotating, it can be prevented that the cleaning liquid scatters over and contaminates the surface of the object to be washed during washing, only the perimeter of the object to be washed can be selectively washed, and manufacturing yields can be increased.

## Claims

1. A plating apparatus for plating an object to be plated such as an electronic component substrate, wherein the apparatus comprises appropriate numbers of a plating bath and baths for washing and the like and is constituted to continuously carry out plating, edge etching, washing and drying therein.

2. The apparatus of claim 1, wherein the apparatus is divided into three areas of a first area in which the plating bath is disposed, a second area in which edge etching, washing and drying are carried out, and a third area which is a loader and unloader area, and the respective areas are separated from one another by means of separation parts.

3. The apparatus of claim 1 or 2, wherein in an electronic component substrate transfer area between the first area in which the plating bath is disposed and the second area in which edge etching, washing and drying are carried out, a BOX which is polyhedral or cylindrical and which has a mechanism for holding an electronic component substrate therein and a shutter on each area side is disposed while the separation between the areas is remained.

4. The apparatus of claim 1 or 2, wherein an electronic component substrate transfer area provided in the separation part between the second area in which edge etching, washing and drying are carried out and the third area which is a loader and unloader area has an opening which is opened and closed by a shutter.

5. The apparatus of any one of claims 1 to 4, wherein the plating bath disposed in the apparatus has a mounting table for the object to be plated on the bottom thereof and a cover which is cylindrical or hollow square, is opened toward the bottom, has a plating solution supply space and covers the object to be plated from the above; a predetermined amount of a plating solution is supplied and stored; and the air inside the cover is released to supply the plating solution from the plating solution supply space into the inside of the cover.

6. The apparatus of any one of claims 1 to 5, wherein the plating bath has an opening corresponding to the plating surface of the object to be plated on the bottom side of the bath, and a cathode electrode which comes in contact with the object to be plated.

7. The apparatus of claim 5 or 6, wherein the cover has an anode electrode opposing to the object to be plated.

8. The apparatus of any one of claims 5 to 7, wherein the cover can be moved freely in a vertical direction in a range of from a seed layer protection energization point right above the object to be plated at which the anode electrode is placed when the plating solution is supplied to the surface of the object to be plated, that is, when energization is initiated, to a predetermined height from the object to be plated which is a standard position.

9. The apparatus of any one of claims 5 to 8, wherein the mounting table for the object to be plated is freely movable in a vertical direction under the plating bath and comes in contact with the cathode electrode and the edge of the opening of the bottom of the plating bath at the highest reachable point to constitute the bottom of the plating bath.

10. The apparatus of any one of claims 5 to 9, wherein a sealing material is attached to the portion of the bottom of the plating bath at which the plating bath comes in contact with the mounting table for the object to be plated.

11. The apparatus of any one of claims 5 to 10, wherein the plating bath has an air releasing valve at the top of the cover.

12. The apparatus of any one of claims 5 to 11, wherein the plating bath has a nitrogen supply pipe on the cover.

13. The apparatus of any one of claims 5 to 12, wherein the plating bath has an air releasing pipe at the top thereof.

14. The apparatus of any one of claims 5 to 13, wherein the plating bath has a solution surface detecting sensor on the side thereof.

15. The apparatus of any one of claims 5 to 14, wherein the plating bath has a drain cover attached to the mounting table for the object to be plated.

16. The apparatus of any one of claims 7 to 15, wherein the anode electrode is a soluble anode such as phosphorus-containing copper or an insoluble anode such as platinum-coated titanium or iridium oxide.

17. The apparatus of any one of claims 1 to 16, wherein the apparatus incorporates a bath for etching the perimeter of the object to be plated and a bath for washing and drying the etched object or a bath for etching, washing and drying the perimeter of the object to be plated, any of these baths comprising a rotating mechanism which holds and rotates the object to be plated, treating liquid supply means for supplying a cleaning liquid to the perimeter of the object to be plated which is held on and rotates with the rotating mechanism, and fluid jetting means for jetting a predetermined fluid from the center side toward the perimeter side of the object to be plated.

18. The apparatus of claim 17, wherein the fluid jetting means is a jet nozzle which jets a predetermined fluid, and is disposed in the vicinity of the treating liquid supply means so as to jet the fluid onto the surface of the object to be plated from the center side toward the perimeter side of the object to be plated.

19. The apparatus of claim 17 or 18, wherein the fluid jetting means is concave from the perimeter side to the center side of the object to be plated, is disposed so as to surround a treating liquid to be supplied from the treating liquid supply means, and is constituted to jet the fluid into the concave portion.

20. The apparatus of any one of claims 17 to 19, wherein the fluid jetting means has a jet nozzle which jets the fluid in an annular shape along the perimeter of the object to be plated from the above, and the treating liquid supply means is disposed in the vicinity of the outside of the jet nozzle.

21. The apparatus of any one of claims 17 to 20, wherein the fluid jetted from the fluid jetting means is a gas such as air, nitrogen, argon, helium or carbon dioxide, or a liquid such as pure water, hydrofluoric acid, ammonia, hydrochloric acid or sulfuric acid.

22. The apparatus of claim 18, wherein the treating liquid supply means is a nozzle which jets a cleaning liquid at the perimeter of the object to be plated.

23. The apparatus of any one of claims 1 to 22, wherein the object to be plated is a disk-shaped semiconductor wafer or had disk.

24. The apparatus of any one of claims 2 to 23, which has a mechanism as the loader for mounting a cassette having an electronic component substrate before the plating therein, and a mechanism as the unloader for mounting the cassette having the electronic component substrate after the plating therein.

25. A plating method using an integral plating apparatus which plates an object to be plated such as an electronic component substrate, wherein the plating apparatus of any one of claims 1 to 24 is applied to the integral plating apparatus to carry out plating.

26. The method of claim 25, wherein in a copper wiring step for an electronic component substrate or semiconductor wafer, a phosphonic acid, amine or acetic acid based electrolytic copper plating solution with a low seed layer dissolving speed and a pH of 6.5 to 8.5 is plated on a copper seed layer formed on a wiring pattern having pits on the electronic component substrate to reinforce the seed layer within the pits of the wiring pattern.

27. The method of claim 25 or 26, wherein the plating to reinforce a seed layer within the pits of a wiring pattern by use of a phosphonic acid, amine or acetic acid based electrolytic copper plating solution having a low seed layer dissolving speed, a pH of 6.5 to 8.5 and a copper concentration of 7 to 12 g/l is carried out as primary plating to form a reinforcement layer, and then secondary plating to fill the pits of the wiring pattern is carried out by use of a copper plating solution having a pH of not higher than 6.5.
